# EUROPEAN PATENT APPLICATION

(11) **EP 4 841 846 A1**
(43) Date of publication of application: **18.11.2026**
(21) Application number: 26168616.6
(22) Date of filing: 27.03.2026
(51) Int. Cl.: H02J 1/102, H02J 3/38, H02J 7/34, H02J 7/50, H02M 1/00, H02M 1/36, H02J 3/32, H02J 7/35

(54) **CONTROL METHOD AND APPARATUS FOR POWER SUPPLY SYSTEM AND POWER SUPPLY SYSTEM**

(30) Priority: 12.05.2025 CN 202510613820
(71) Applicant: Shanghai Sigeyuan Intelligent Technology Co., Ltd, Shanghai 201306 (CN)
(72) Inventor: KE, Jin, Shanghai, 201306 (CN); ZHU, Yunliang, Shanghai, 201306 (CN)
(74) Representative: Di Bernardo, Antonio

(57) **Abstract**

The present disclosure discloses a control method and apparatus for a power supply system, and a power supply system, and belongs to the technical field of power supply. The power supply system includes an energy storage device, a direct-current converter, and a grid-connected converter. The direct-current converter has an end connected to the energy storage device and another end connected to a direct-current bus. The grid-connected converter has an end connected to the direct-current bus and another end configured to be connected to the power grid. The method includes: when the power supply system is in a black-start process and the at least two power conversion circuits are connected in a first electrical connection mode, in response to a voltage of the direct-current bus being less than a first voltage threshold, controlling the direct-current converter to output electric energy from the energy storage device to the direct-current bus; in response to the voltage of the direct-current bus being greater than or equal to the first voltage threshold and the grid-connected converter being activated, obtaining voltage information at the end of the grid-connected converter that is connected to the direct-current bus; and adjusting an electrical connection mode between the at least two power conversion circuits in the direct-current converter based on the voltage information, such that a direct-current output voltage of the direct-current converter matches a voltage at the end of the grid-connected converter that is connected to the direct-current bus.

## Description

### FIELD

The present disclosure belongs to the technical field of power supply, and more particularly, relates to a control method and apparatus for a power supply system, and a power supply system.

### BACKGROUND

A photovoltaic-storage system coupled with a direct-current bus generally includes a direct-current converter. The system can operate at different direct-current bus voltage levels, which are generally classified into a low voltage level (500V to 650V) and a high voltage level (1000V to 1100V). Regardless of the voltage level, the direct-current converter that is coupled to the direct-current bus for charging and discharging of an energy storage device must meet the corresponding voltage withstand requirement.

At present, during a black-start process of the photovoltaic-storage system with no grid input and no sunlight, the direct-current bus voltage level to be supported by the direct-current converter cannot be determined. Therefore, a direct-current converter with high voltage withstand is usually adopted to meet the voltage withstand requirement of the high voltage level. However, the material cost of components in the direct-current converter with high voltage withstand is relatively high, thereby increasing the cost of the photovoltaic-storage system.

### SUMMARY

The present disclosure aims to solve at least one of the technical problems existing in the prior art. To this end, the present disclosure proposes a control method and apparatus for a power supply system and a power supply system, which can adjust an electrical connection mode between at least two power conversion circuits during a black-start process, to lower voltage withstand requirements of the power conversion circuits, thereby reducing the cost of a direct-current converter and the cost of a photovoltaic-storage system.

In a first aspect, the present disclosure provides a control method for a power supply system. The power supply system includes an energy storage device, a direct-current converter, and a grid-connected converter. The direct-current converter includes at least two power conversion circuits. The direct-current converter has an end connected to the energy storage device and another end connected to a direct-current bus, and the grid-connected converter has an end connected to the direct-current bus and another end configured to be connected to the power grid; and the method includes: when the power supply system is in a black-start process and the at least two power conversion circuits are connected in a first electrical connection mode, in response to a voltage of the direct-current bus being less than a first voltage threshold, controlling the direct-current converter to output electric energy from the energy storage device to the direct-current bus; in response to the voltage of the direct-current bus being greater than or equal to the first voltage threshold and the grid-connected converter being activated, obtaining voltage information at the end of the grid-connected converter that is connected to the direct-current bus; and adjusting an electrical connection mode between the at least two power conversion circuits in the direct-current converter based on the voltage information, such that a direct-current output voltage of the direct-current converter matches a voltage at the end of the grid-connected converter that is connected to the direct-current bus.

With the control method for the power supply system according to the present disclosure, during the black-start process, when the voltage of the direct-current bus reaches the first voltage threshold, the grid-connected converter is activated and outputs the voltage information. The voltage information is obtained through a predetermined communication mode, and the electrical connection mode between the at least two power conversion circuits is adjusted based on the voltage information, so that the direct-current output voltage of the direct-current converter matches the voltage at the end of the grid-connected converter that is connected to the direct-current bus. When a relatively high direct-current output voltage is required, the electrical connection mode can be adjusted to achieve voltage sharing among a plurality of power conversion circuits, which lowers the voltage withstand requirements of the power conversion circuits, thereby reducing the cost of the direct-current converter and the cost of the photovoltaic-storage system.

According to an embodiment of the present disclosure, adjusting the electrical connection mode between the at least two power conversion circuits in the direct-current converter based on the voltage information includes: determining a voltage level of the voltage at the end of the grid-connected converter that is connected to the direct-current bus based on the voltage information; and based on the voltage level, adjusting the at least two power conversion circuits to be connected in a second electrical connection mode, or maintaining the at least two power conversion circuits to be connected in the first electrical connection mode. The direct-current output voltage corresponding to the second electrical connection mode is higher than the direct-current output voltage corresponding to the first electrical connection mode.

According to an embodiment of the present disclosure, the voltage levels include a first voltage level and a second voltage level, the first voltage level being higher than the second voltage level; and based on the voltage level, adjusting the at least two power conversion circuits to be connected in the second electrical connection mode, or maintaining the at least two power conversion circuits to be connected in the first electrical connection mode includes: adjusting the at least two power conversion circuits to be connected in the second electrical connection mode in response to the voltage level being the first voltage level.

According to an embodiment of the present disclosure, the voltage levels include a first voltage level and a second voltage level, the first voltage level being higher than the second voltage level; and based on the voltage level, adjusting the at least two power conversion circuits to be connected in the second electrical connection mode, or maintaining the at least two power conversion circuits to be connected in the first electrical connection mode includes: maintaining the at least two power conversion circuits to be connected in the first electrical connection mode in response to the voltage level being the second voltage level.

According to an embodiment of the present disclosure, adjusting the electrical connection mode between the at least two power conversion circuits in the direct-current converter based on the voltage information includes: adjusting the at least two power conversion circuits to be connected in series and/or in parallel based on the voltage information.

According to an embodiment of the present disclosure, the method further includes, subsequent to the obtaining the voltage information at the end of the grid-connected converter that is connected to the direct-current bus and prior to the adjusting the electrical connection mode between the at least two power conversion circuits in the direct-current converter: controlling the at least two power conversion circuits to stop operating.

In a second aspect, the present disclosure provides a control apparatus for a power supply system. The power supply system includes an energy storage device, a direct-current converter, and a grid-connected converter. The direct-current converter includes at least two power conversion circuits. The direct-current converter has an end connected to the energy storage device and another end connected to a direct-current bus, and the grid-connected converter has an end connected to the direct-current bus and another end configured to be connected to the power grid; and the apparatus includes: a first processing module configured to, when the power supply system is in a black-start process and the at least two power conversion circuits are connected in a first electrical connection mode, control the direct-current converter to output electric energy from the energy storage device to the direct-current bus in response to a voltage of the direct-current bus being less than a first voltage threshold; a second processing module configured to obtain voltage information at the end of the grid-connected converter that is connected to the direct-current bus in response to the voltage of the direct-current bus being greater than or equal to the first voltage threshold and the grid-connected converter being activated; and a third processing module configured to adjust an electrical connection mode between the at least two power conversion circuits in the direct-current converter based on the voltage information, such that a direct-current output voltage of the direct-current converter matches a voltage at the end of the grid-connected converter that is connected to the direct-current bus.

With the control apparatus for the power supply system according to the present disclosure, during the black-start process, when the voltage of the direct-current bus reaches the first voltage threshold, the grid-connected converter is activated and outputs the voltage information. The voltage information is obtained through the predetermined communication mode, and the electrical connection mode between the at least two power conversion circuits is adjusted based on the voltage information, so that the direct-current output voltage of the direct-current converter matches the voltage at the end of the grid-connected converter that is connected to the direct-current bus. When the relatively high direct-current output voltage is required, the electrical connection mode can be adjusted to achieve the voltage sharing among the plurality of power conversion circuits, which lowers the voltage withstand requirements of the power conversion circuits, thereby reducing the cost of the direct-current converter and the cost of the photovoltaic-storage system.

In a third aspect, the present disclosure provides a power supply system. The power supply system includes: an energy storage device; a direct-current converter including at least two power conversion circuits, an end of the direct-current converter being connected to the energy storage device, and another end of the direct-current converter being connected to a direct-current bus; and a grid-connected converter. An end of the grid-connected converter is connected to the direct-current bus, and another end of the grid-connected converter is configured to be connected to the power grid. The direct-current converter further includes a first controller configured to execute the control method for the power supply system according to the first aspect.

With the power supply system according to the present disclosure, during the black-start process, when the voltage of the direct-current bus reaches the first voltage threshold, the grid-connected converter is activated and outputs the voltage information. The voltage information is obtained through the predetermined communication mode, and the electrical connection mode between the at least two power conversion circuits is adjusted based on the voltage information, so that the direct-current output voltage of the direct-current converter matches the voltage at the end of the grid-connected converter that is connected to the direct-current bus. When the relatively high direct-current output voltage is required, the electrical connection mode can be adjusted to achieve the voltage sharing among the plurality of power conversion circuits, which lowers the voltage withstand requirements of the power conversion circuits, thereby reducing the cost of the direct-current converter and the cost of the photovoltaic-storage system.

According to an embodiment of the present disclosure, the direct-current converter further includes: a switching circuit connected to output ends of the at least two power conversion circuits. The switching circuit includes a plurality of switching devices. The first controller is configured to control a switching state of each of the plurality of switching devices to adjust an electrical connection mode between the at least two power conversion circuits.

According to an embodiment of the present disclosure, the grid-connected converter includes: a second controller communicatively connected to the first controller. The second controller is configured to transmit voltage information at the end of the grid-connected converter that is connected to the direct-current bus to the first controller in response to a voltage of the direct-current bus being greater than or equal to the first voltage threshold and the grid-connected converter being activated.

In a fourth aspect, the present disclosure provides an electronic device. The electronic device includes a memory, a processor, and a computer program that is stored on the memory and executable on the processor. The computer program is configured to implement, when executed by the processor, implement the control method for the power supply system according to the first aspect.

In a fifth aspect, the present disclosure provides a non-transitory computer-readable storage medium. The non-transitory computer-readable storage medium has a computer program stored thereon. The computer program is configured to implement, when executed by a processor, the control method for the power supply system according to the first aspect above.

In a sixth aspect, the present disclosure provides a computer program product. The computer program product includes a computer program configured to implement, when executed by a processor, the control method for the power supply system according to the first aspect above.

Additional aspects and advantages of the present disclosure will be provided in part in the following description, or will become apparent in part from the following description, or can be learned from practicing of the present disclosure.

### BRIEF DESCRIPTION OF THE DRAWINGS

The above and/or additional aspects and advantages of the present disclosure will become apparent and readily understood from the following description of embodiments taken in conjunction with the accompanying drawings, in which:
FIG. 1 is a first schematic flowchart of a control method for a power supply system according to an embodiment of the present disclosure.
FIG. 2 is a second schematic flowchart of a control method for a power supply system according to an embodiment of the present disclosure.
FIG. 3 is a first schematic structural diagram of a power supply system according to an embodiment of the present disclosure.
FIG. 4 is a second schematic structural diagram of a power supply system according to an embodiment of the present disclosure.
FIG. 5 is a schematic structural diagram of a direct-current converter according to an embodiment of the present disclosure.
FIG. 6 is a schematic structural diagram of a grid-connected converter according to an embodiment of the present disclosure.
FIG. 7 is a schematic structural diagram of a control apparatus for a power supply system according to an embodiment of the present disclosure.
FIG. 8 is a schematic structural diagram of an electronic device according to an embodiment of the present disclosure.

### Reference numerals:

energy storage device 310, direct-current converter 320, grid-connected converter 330, direct-current bus 340, power grid 200,
power conversion circuit 321, first controller 322, first auxiliary power supply 323, switching circuit 324,
black-start switch 325, second controller 331, second auxiliary power supply 332, power conversion unit 333.

### DETAILED DESCRIPTION OF THE EMBODIMENTS

Technical solutions according to embodiments of the present disclosure will be described clearly below in combination with accompanying drawings of the embodiments of the present disclosure. Obviously, the embodiments described below are a part of the embodiments of the present disclosure, rather than all embodiments of the present disclosure. On a basis of the embodiments of the present disclosure, all other embodiments obtained by those skilled in the art shall fall within the scope of the present disclosure.

Terms such as "first" and "second" in the specification and claims of the present disclosure are used only to distinguish between similar objects, rather than to describe a particular order or sequence. It should be understood that the data as used can be interchanged where appropriate, to enable the embodiments of the present disclosure described herein to be implemented in an order other than that illustrated or described herein. Also, the objects distinguished by the terms such as "first" and "second" are usually objects of the same type. The quantity of objects is not limited. For example, a first object may be one first object or a plurality of first objects. In addition, "and/or" throughout the specification and claims indicates at least one of the objects associated with "and/or". The character "/" generally indicates that the associated objects before and after the character are in an "or" relationship.

A control method for a power supply system, a control apparatus for a power supply system, a power supply system, an electronic device, and a readable storage medium according to the embodiments of the present disclosure will be described below in detail with reference to specific embodiments and application scenarios thereof in combination with the accompanying drawings.

In the control method for the power supply system according to the embodiments of the present disclosure, an execution subject of the control method for the power supply system may be an electronic device or a functional module or a functional entity in the electronic device that is capable of implementing the control method for the power supply system. The control method for the power supply system according to the embodiments of the present disclosure will be described below by taking the electronic device serving as the execution subject as an example.

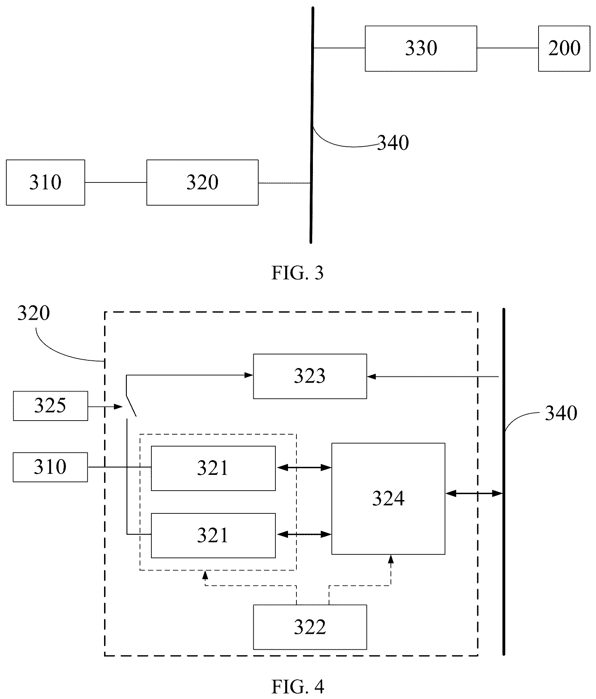

As shown in FIG. 3, the power supply system includes an energy storage device 310, a direct-current converter 320, and a grid-connected converter 330. The direct-current converter 320 includes at least two power conversion circuits 321. The direct-current converter 320 has an end connected to the energy storage device 310 and another end connected to a direct-current bus 340. The grid-connected converter 330 has an end connected to the direct-current bus 340 and another end configured to be connected to the power grid 200.

The energy storage device 310 is a device capable of storing received electric energy and outputting the stored electric energy. The direct-current converter 320 is a device capable of converting a direct-current voltage of one level into a direct-current voltage of another different level. The grid-connected converter 330 is a device capable of converting one form of electric energy into another form of electric energy. The direct-current bus 340 is a common conductor in the power supply system for collecting and distributing direct-current electric energy.

The direct-current converter 320 includes at least two power conversion circuits 321. The power conversion circuits 321 can convert a direct-current voltage of one level into a direct-current voltage of another different level.

Each of the power conversion circuits 321 in the direct-current converter 320 has an end connected to the energy storage device 310 and another end connected to the direct-current bus 340. The direct-current electric energy on the direct-current bus 340 may be converted and transmitted to the energy storage device 310 for storage through the power conversion circuits 321. The electric energy stored in the energy storage device 310 may also be converted and transmitted to the direct-current bus 340 through the power conversion circuits 321.

The grid-connected converter 330 has an end connected to the direct-current bus 340 and another end configured to be connected to the power grid 200. Alternating-current electric energy of the power grid 200 may be converted into the direct-current electric energy through the grid-connected converter 330 and transmitted to the direct-current bus 340. The direct-current electric energy on the direct-current bus 340 may also be converted into the alternating-current electric energy through the grid-connected converter 330 and transmitted to the power grid 200.

The direct-current bus 340 may also be connected to a photovoltaic module, which converts solar light energy into the direct-current electric energy and transmits the direct-current electric energy to the direct-current bus 340.

The control method for the power supply system according to the embodiments of the present disclosure is used to: when the direct-current bus 340 is powered off and the power supply system is in a black-start process, automatically match and output a voltage required by the direct-current bus 340 after completion of black-start to the direct-current bus 340, based on voltage information at an end of the grid-connected converter 330 connected to the direct-current bus 340.

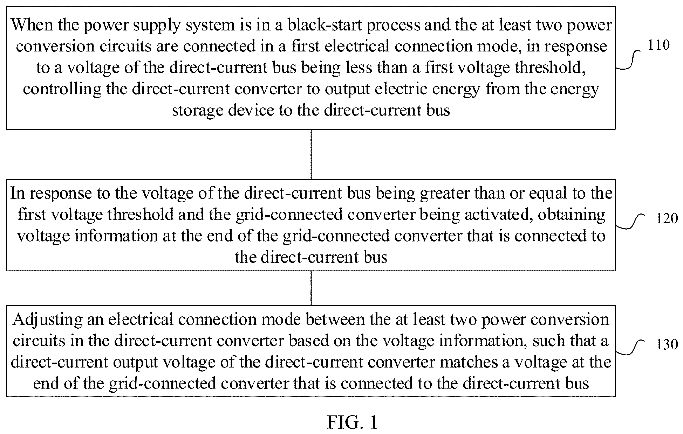

As shown in FIG. 1, the control method for the power supply system includes actions at steps 110, 120, and 130.

At step 110, when the power supply system is in a black-start process and the at least two power conversion circuits 321 are connected in a first electrical connection mode, in response to a voltage of the direct-current bus 340 being less than a first voltage threshold, the direct-current converter 320 is controlled to output electric energy from the energy storage device 310 to the direct-current bus 340.

The first electrical connection mode may be a parallel connection.

In this embodiment, the direct-current bus 340 of the power supply system is powered off, and the power supply system enters the black-start process. At an initial stage when the power supply system enters the black-start process, the at least two power conversion circuits 321 are controlled to be connected in the first electrical connection mode.

In this embodiment, the first voltage threshold is a predetermined voltage. The voltage of the direct-current bus 340 being less than the first voltage threshold indicates that the power grid 200 and the photovoltaic module cannot supply electric energy to the direct-current bus 340, indicating that the direct-current bus 340 is powered off. That is, it is determined that the direct-current bus 340 is powered off and the power supply system enters the black-start process by detecting that the voltage of the direct-current bus 340 is less than the first voltage threshold.

When the power supply system is in the black-start process, the direct-current converter 320 is controlled to output the electric energy from the energy storage device 310 to the direct-current bus 340. The electric energy from the energy storage device 310 is converted by the direct-current converter 320 and then outputted to the direct-current bus 340, to continuously boost the voltage of the direct-current bus 340.

At step 120, in response to the voltage of the direct-current bus 340 being greater than or equal to the first voltage threshold and the grid-connected converter 330 being activated, voltage information at the end of the grid-connected converter 330 connected to the direct-current bus 340 is obtained.

The voltage information may include a magnitude of a voltage value or a level of a voltage at the end of the grid-connected converter 330 connected to the direct-current bus 340.

In this step, the voltage of the direct-current bus 340 is continuously boosted. After the voltage of the direct-current bus 340 is boosted to the first voltage threshold, internal components of the grid-connected converter 330 can obtain the electric energy from the direct-current bus 340, so that the grid-connected converter 330 is activated. After the grid-connected converter 330 is activated, the grid-connected converter 330 can output the voltage information, and the voltage information outputted by the grid-connected converter 330 can be obtained through a predetermined communication mode.

At step 130, an electrical connection mode between the at least two power conversion circuits 321 in the direct-current converter 320 is adjusted based on the voltage information, such that a direct-current output voltage of the direct-current converter 320 matches the voltage at the end of the grid-connected converter 330 connected to the direct-current bus 340.

It can be understood that the direct-current output voltage of the direct-current converter 320 needs to match the voltage at the end of the grid-connected converter 330 connected to the direct-current bus 340, to enable the power supply system to operate stably.

After the voltage information is obtained, in order to enable the power supply system to operate stably, the electrical connection mode between the at least two power conversion circuits 321 in the direct-current converter 320 is adjusted based on the magnitude of the voltage value at the end of the grid-connected converter 330 connected to the direct-current bus 340, to adjust the direct-current output voltage of the direct-current converter 320.

In the related art, during the black-start process of the photovoltaic-storage system with no grid input and no sunlight, the direct-current bus voltage level to be supported by the direct-current converter cannot be determined. Therefore, a direct-current converter with high voltage withstand is usually adopted to meet a voltage withstand requirement of the high voltage level. However, the material cost of components in the direct-current converter with high voltage withstand is relatively high, thereby increasing the cost of the photovoltaic-storage system.

With the control method for the power supply system according to the embodiments of the present disclosure, during the black-start process, when the voltage of the direct-current bus 340 reaches the first voltage threshold, the grid-connected converter 330 is activated and outputs the voltage information. The voltage information is obtained through the predetermined communication mode, and the electrical connection mode between the at least two power conversion circuits 321 is adjusted based on the voltage information, so that the direct-current output voltage of the direct-current converter 320 matches the voltage at the end of the grid-connected converter 330 connected to the direct-current bus 340. When a relatively high direct-current output voltage is required, the electrical connection mode can be adjusted to achieve voltage sharing among a plurality of power conversion circuits 321 , which lowers voltage withstand requirements of the power conversion circuits 321, thereby reducing the cost of the direct-current converter 320, and reducing the cost of the photovoltaic-storage system.

In some embodiments, the adjusting the electrical connection mode between the at least two power conversion circuits 321 in the direct-current converter 320 based on the voltage information includes: determining a voltage level of the voltage at the end of the grid-connected converter 330 connected to the direct-current bus 340 based on the voltage information; and based on the voltage level, adjusting the at least two power conversion circuits 321 to be connected in a second electrical connection mode, or maintaining the at least two power conversion circuits 321 to be connected in the first electrical connection mode. The direct-current output voltage corresponding to the second electrical connection mode is higher than the direct-current output voltage corresponding to the first electrical connection mode.

In this embodiment, the voltage at the end of the grid-connected converter 330 connected to the direct-current bus 340 may be divided into a plurality of voltage levels. Each of the plurality of voltage levels may correspond to a predetermined voltage range, and the voltage information may include a magnitude of the voltage value at the end of the grid-connected converter 330 connected to the direct-current bus 340. The voltage value at the end of the grid-connected converter 330 connected to the direct-current bus 340 is compared with the predetermined voltage range to determine a corresponding voltage level.

For example, a voltage less than 500V corresponds to one voltage level, a voltage ranging from 500V to 650V corresponds to one voltage level, a voltage ranging from 650V to 1000V corresponds to one voltage level, a voltage ranging from 1000Vto 1100V corresponds to one voltage level, and a voltage greater than 1100V corresponds to one voltage level. In response to the voltage at the end of the grid-connected converter 330 connected to the direct-current bus 340 being 700V, it is determined that the voltage level of the voltage at the end of the grid-connected converter 330 connected to the direct-current bus 340 is the voltage level corresponding to the voltage ranging from 650V to 1000V.

In this embodiment, each of the plurality of voltage levels may correspond to a different electrical connection mode. The electrical connection mode include the first electrical connection mode and the second electrical connection mode. The direct-current output voltage when the at least two power conversion circuits 321 are connected in the second electrical connection mode is higher than that when they are connected in the first electrical connection mode. When a required direct-current output voltage is relatively high, the two power conversion circuits 321 may be selected to be connected in the second electrical connection mode. When the required direct-current output voltage is relatively low, the two power conversion circuits 321 may be selected to be connected in the first electrical connection mode.

The magnitude of the required direct-current output voltage may be determined based on the voltage level. The at least two power conversion circuits 321 are adjusted to be connected in the second electrical connection mode or maintained to be connected in the first electrical connection mode.

In some embodiments, the voltage level includes a first voltage level and a second voltage level. The first voltage level is higher than the second voltage level. The adjusting the at least two power conversion circuits 321 to be connected in the second electrical connection mode, or maintaining the at least two power conversion circuits 321 to be connected in the first electrical connection mode based on the voltage level includes: adjusting the at least two power conversion circuits 321 to be connected in the second electrical connection mode in response to the voltage level being the first voltage level.

In this embodiment, the voltage levels are divided into two levels: a high voltage level and a low voltage level. The first voltage level is the high voltage level, and the second voltage level is the low voltage level.

When the voltage level is the first voltage level, it is determined that the required direct-current output voltage is relatively high, and the at least two power conversion circuits 321 are adjusted to be connected in the second electrical connection mode. The plurality of power conversion circuits 321 share the provision of the direct-current output voltage, so that the direct-current output voltage matches the first voltage level.

In some embodiments, the voltage level includes a first voltage level and a second voltage level. The first voltage level is higher than the second voltage level. The adjusting the at least two power conversion circuits 321 to be connected in the second electrical connection mode, or maintaining the at least two power conversion circuits 321 to be connected in the first electrical connection mode based on the voltage level, includes: maintaining the at least two power conversion circuits 321 to be connected in the first electrical connection mode in response to the voltage level being the second voltage level.

When the voltage level is the second voltage level, it is determined that the required direct-current output voltage is relatively low, and the at least two power conversion circuits 321 are maintained to be connected in the first electrical connection mode, so that the direct-current output voltage matches the second voltage level.

In some embodiments, the adjusting the electrical connection mode between the at least two power conversion circuits 321 in the direct-current converter 320 based on the voltage information includes: adjusting the at least two power conversion circuits 321 to be connected in series and/or in parallel based on the voltage information.

In this embodiment, when the direct-current converter 320 includes two power conversion circuits 321, the two power conversion circuits 321 may be adjusted to be connected in series or in parallel based on the voltage information.

When the direct-current converter 320 includes two or more power conversion circuits 321, the plurality of power conversion circuits 321 may be adjusted to be connected in series, in parallel, or in a combination of series and parallel connections based on the voltage information.

A specific embodiment of the control method for the power supply system is described below.

In this embodiment, the first electrical connection mode may be a parallel connection, and the second electrical connection mode may be a series connection.

The direct-current bus 340 of the power supply system is powered off, and the power supply system enters the black-start process. At the initial stage when the power supply system enters the black-start process, the at least two power conversion circuits 321 are controlled to be connected in parallel. Each of the at least two power conversion circuits 321 can operate independently. When one of the power conversion circuits 321 fails, the other circuits can still continue to operate, thereby ensuring the reliability of the system.

The direct-current converter 320 is controlled to output the electric energy from the energy storage device 310 to the direct-current bus 340. In response to the voltage of the direct-current bus 340 being greater than or equal to the first voltage threshold and the grid-connected converter 330 being activated, the voltage information at the end of the grid-connected converter 330 connected to the direct-current bus 340 is obtained.

In response to determining that the voltage level at the end of the grid-connected converter 330 connected to the direct-current bus 340 is the first voltage level based on the voltage information, the at least two power conversion circuits 321 are adjusted to be connected in series, and voltages of the plurality of power conversion circuits 321 are superposed, to meet a high voltage output requirement, thereby enabling high voltage output using a power conversion circuit 321 with a relatively low voltage level.

In response to determining that the voltage level at the end of the grid-connected converter 330 connected to the direct-current bus 340 is the second voltage level based on the voltage information, the at least two power conversion circuits 321 are maintained to be connected in parallel.

In some embodiments, subsequent to the obtaining the voltage information at the end of the grid-connected converter 330 connected to the direct-current bus 340 and prior to the adjusting the electrical connection mode between the at least two power conversion circuits 321 in the direct-current converter 320, the method further includes: controlling the at least two power conversion circuits 321 to stop operating.

In this embodiment, before adjusting the electrical connection mode between the at least two power conversion circuits 321 in the direct-current converter 320, the at least two power conversion circuits 321 are controlled to stop operating, which can reduce current impact or voltage transient in the power conversion circuits 321 and improve operation safety of the direct-current converter 320.

The control method for the power supply system according to the embodiments of the present disclosure may be executed by the control apparatus for the power supply system. In the embodiments of the present disclosure, the control method for the power supply system executed by the control apparatus for the power supply system is taken as an example to illustrate the control apparatus for the power supply system according to the embodiments of the present disclosure.

Embodiments of the present disclosure also provide a control apparatus for a power supply system.

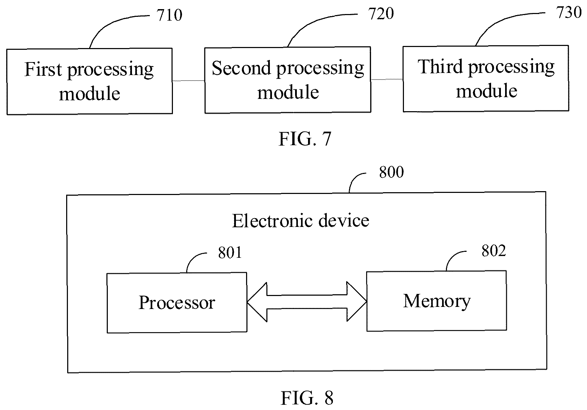

As shown in FIG. 7, the control apparatus for the power supply system includes: a first processing module 710 configured to, when the power supply system is in a black-start process and the at least two power conversion circuits 321 are connected in a first electrical connection mode, control the direct-current converter 320 to output electric energy from the energy storage device 310 to the direct-current bus 340 in response to a voltage of the direct-current bus 340 being less than a first voltage threshold; a second processing module 720 configured to obtain voltage information at the end of the grid-connected converter 330 connected to the direct-current bus 340 in response to the voltage of the direct-current bus 340 being greater than or equal to the first voltage threshold and the grid-connected converter 330 being activated; and a third processing module 730 configured to adjust an electrical connection mode between the at least two power conversion circuits 321 in the direct-current converter 320 based on the voltage information, such that a direct-current output voltage of the direct-current converter 320 matches a voltage at the end of the grid-connected converter 330 connected to the direct-current bus 340.

With the control apparatus for the power supply system according to the embodiments of the present disclosure, during the black-start process, when the voltage of the direct-current bus 340 reaches the first voltage threshold, the grid-connected converter 330 is activated and outputs the voltage information. The voltage information is obtained through the predetermined communication mode, and the electrical connection mode between the at least two power conversion circuits 321 is adjusted based on the voltage information, so that the direct-current output voltage of the direct-current converter 320 matches the voltage at the end of the grid-connected converter 330 connected to the direct-current bus 340. When the relatively high direct-current output voltage is required, the electrical connection mode is adjusted to achieve the voltage sharing among the plurality of power conversion circuits 321, which lowers the voltage withstand requirements of the power conversion circuits 321, thereby reducing the cost of the direct-current converter 320 and the cost of the photovoltaic-storage system.

In some embodiments, the third processing module 730 is configured to: determine a voltage level of the voltage at the end of the grid-connected converter 330 connected to the direct-current bus 340 based on the voltage information; and based on the voltage level, adjust the at least two power conversion circuits 321 to be connected in a second electrical connection mode, or maintaining the at least two power conversion circuits 321 to be connected in the first electrical connection mode. The direct-current output voltage corresponding to the second electrical connection mode is higher than the direct-current output voltage corresponding to the first electrical connection mode.

In some embodiments, the voltage level includes a first voltage level and a second voltage level. The first voltage level is higher than the second voltage level. The third processing module 730 is configured to adjust the at least two power conversion circuits 321 to be connected in the second electrical connection mode in response to the voltage level being the first voltage level.

In some embodiments, the voltage level includes a first voltage level and a second voltage level. The first voltage level is higher than the second voltage level. The third processing module 730 is configured to maintain the at least two power conversion circuits 321 to be connected in the first electrical connection mode in response to the voltage level being the second voltage level.

In some embodiments, the third processing module 730 is configured to adjust the at least two power conversion circuits 321 to be connected in series and/or in parallel based on the voltage information.

In some embodiments, the third processing module 730 is further configured to control the at least two power conversion circuits 321 to stop operating.

The control apparatus for the power supply system according to the embodiments of the present disclosure may be an electronic device, or a component in the electronic device, such as an integrated circuit or a chip.

The control apparatus for the power supply system according to the embodiments of the present disclosure may be an apparatus having an operating system. The operating system may be an Android operating system, an IOS operating system, or other possible operating systems, which are not specifically limited in the embodiments of the present disclosure.

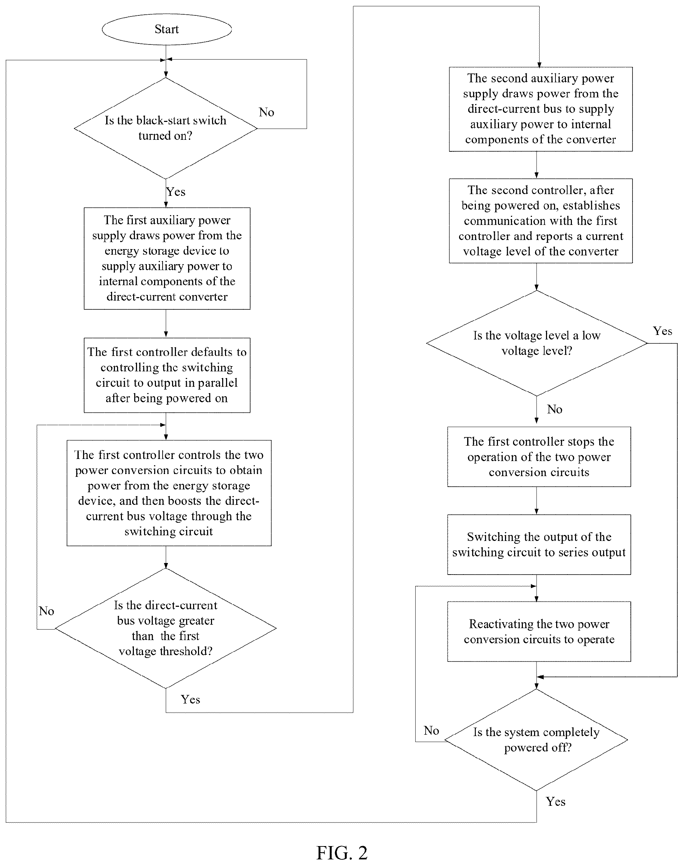

The control apparatus for the power supply system according to the embodiments of the present disclosure can implement each process implemented by the method embodiments of FIGS. 1 and 2, and details thereof are omitted herein to avoid redundancy.

Embodiments of the present disclosure further provide a power supply system.

As shown in FIG. 3, the power supply system includes an energy storage device 310, a direct-current converter 320, and a grid-connected converter 330.

The direct-current converter 320 includes at least two power conversion circuits 321. An end of the direct-current converter 320 is connected to the energy storage device 310, and another end of the direct-current converter 320 is connected to a direct-current bus 340. An end of the grid-connected converter 330 is connected to the direct-current bus 340, and another end of the grid-connected converter 330 is configured to be connected to the power grid 200.

The direct-current converter 320 further includes a first controller 322 configured to execute the control method for the power supply system described above.

As shown in FIG. 4, the direct-current converter 320 includes two power conversion circuits 321, a black-start switch 325, a first auxiliary power supply 323, and a first controller 322.

The first auxiliary power supply 323 may draw power from the direct-current bus 340 or draw power from the energy storage device 310 via the black-start switch 325 to supply auxiliary power to internal components of the direct-current converter 320.

After the direct-current bus 340 is powered off and the black-start switch 325 is turned on, the first auxiliary power supply 323 draws power from the energy storage device 310 to supply the auxiliary power to the internal components of the direct-current converter 320. After being powered on, the first controller 322 defaults to controlling the two power conversion circuits 321 to be connected in parallel, and controls the activation of the two power conversion circuits 321 to enter an operating state. The two power conversion circuits 321 obtain power from the energy storage device 310 and then boost the voltage of the direct-current bus 340.

With the power supply system according to the embodiments of the present disclosure, during the black-start process, when the voltage of the direct-current bus 340 reaches the first voltage threshold, the grid-connected converter 330 is activated and outputs the voltage information. The voltage information is obtained through the predetermined communication mode, and the electrical connection mode between the at least two power conversion circuits 321 is adjusted based on the voltage information, so that the direct-current output voltage of the direct-current converter 320 matches the voltage at the end of the grid-connected converter 330 connected to the direct-current bus 340. When the relatively high direct-current output voltage is required, the electrical connection mode can be adjusted to achieve the voltage sharing among the plurality of power conversion circuits 321, which lowers the voltage withstand requirements of the power conversion circuits 321, thereby reducing the cost of the direct-current converter 320 and the cost of the photovoltaic-storage system.

In some embodiments, as shown in FIG. 4, the direct-current converter 320 further includes a switching circuit 324.

The switching circuit 324 is connected to output ends of the at least two power conversion circuits 321. The switching circuit 324 includes a plurality of switching devices. The first controller 322 is configured to control a switching state of each of the plurality of switching devices to adjust an electrical connection mode between the at least two power conversion circuits 321.

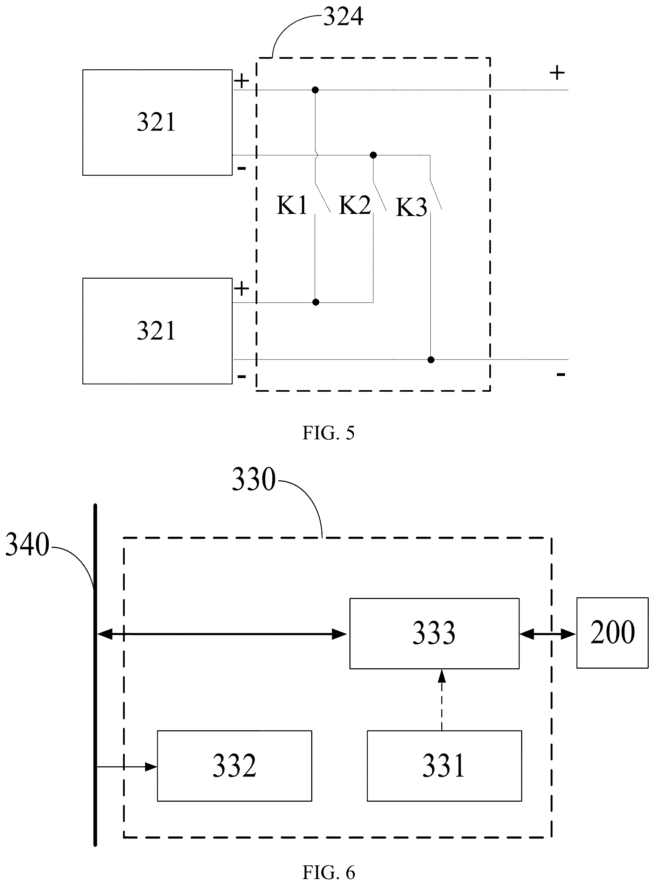

As shown in FIG. 5, the switching circuit 324 includes a switching device K1, a switching device K2, and a switching device K3. When the first controller 322 controls the switching device K1 and the switching device K3 to be turned on, and controls the switching device K2 to be turned off, the two power conversion circuits 321 are connected in parallel. When the first controller 322 controls the switching device K2 to be turned on, and controls the switching device K1 and the switching device K3 to be turned off, the two power conversion circuits 321 are connected in series.

In some embodiments, the grid-connected converter 330 includes a second controller 331.

The second controller 331 is communicatively connected to the first controller 322. The second controller 331 is configured to transmit voltage information at the end of the grid-connected converter 330 connected to the direct-current bus 340 to the first controller 322 in response to a voltage of the direct-current bus 340 being greater than or equal to the first voltage threshold and the grid-connected converter 330 being activated.

As shown in FIG. 6, the grid-connected converter 330 includes a power conversion unit 333, a second auxiliary power supply 332, and a second controller 331. When the voltage of the direct-current bus 340 is greater than or equal to the first voltage threshold, the second auxiliary power supply 332 obtains electric energy from the direct-current bus 340 to supply the auxiliary power to the internal components of the grid-connected converter 330. After being powered on, the second controller 331 establishes communication with the first controller 322 and transmits the voltage information to the first controller 322.

With the control method for the power supply system according to the embodiments of the present disclosure, after the power supply system is completely powered off, during the black-start process, a voltage of the direct-current bus 340 required after the black-start can be automatically matched based on the voltage level of the grid-connected converter 330, to determine a direct-current output voltage, thereby improving adaptability of the system in different scenarios while its safety and reliability are ensured.

A specific embodiment of the control method for the power supply system when the power supply system is configured with a grid-connected converter 330 of a low voltage level is described below.

The direct-current converter 320 includes two power conversion circuits 321. After the black-start switch 325 is turned on, the first auxiliary power supply 323 draws power from the energy storage device 310 to supply the auxiliary power to the internal components of the direct-current converter 320. After being powered on, the first controller 322 defaults to controlling the switching circuit 324 to operate in parallel output, i.e., the two power conversion circuits 321 are connected in parallel, and are controlled and activated to enter the operating state. The two power conversion circuits 321 obtain power from the energy storage device 310 and then boost the voltage of the direct-current bus 340 via the switching circuit 324. When the voltage of the direct-current bus 340 reaches the first voltage threshold, the second auxiliary power supply 332 obtains power from the direct-current bus 340 to supply the auxiliary power to the internal components of the grid-connected converter 330. After being powered on, the second controller 331 establishes communication with the first controller 322 and notifies that a current voltage level of the grid-connected converter 330 is the low voltage level, i.e., the second voltage level. Since the first controller 322 defaults to controlling the switching circuit 324 to operate in parallel output after being powered on, the first controller 322 continues to maintain the current operating state and continues to operate after receiving the information that the grid-connected converter 330 is at the low voltage level.

A specific embodiment of the control method for the power supply system when the power supply system is configured with a grid-connected converter 330 of a high voltage level is described below.

The direct-current converter 320 includes two power conversion circuits 321. After the black-start switch 325 is turned on, the first auxiliary power supply 323 draws power from the energy storage device 310 to supply the auxiliary power to the internal components of the direct-current converter 320. After being powered on, the first controller 322 defaults to controlling the switching circuit 324 to operate in parallel output, i.e., the two power conversion circuits 321 are connected in parallel, and are controlled and activated to enter the operating state. The two power conversion circuits 321 obtain power from the energy storage device 310 and then boost the voltage of the direct-current bus 340 via the switching circuit 324. When the voltage of the direct-current bus 340 reaches the first voltage threshold, the second auxiliary power supply 332 obtains power from the direct-current bus 340 to supply the auxiliary power to the internal components of the grid-connected converter 330. After being powered on, the second controller 331 establishes communication with the first controller 322 and notifies that the current voltage level of the grid-connected converter 330 is the high voltage level, i.e., the first voltage level. Since the first controller 322 defaults to controlling the switching circuit 324 to operate in parallel output after being powered on, after information that the grid-connected converter 330 is at the high voltage level is received, the first controller 322 stops the two power conversion circuits 321 from operating, then switches output of the switching circuit 324 to series output, and reactivates the two power conversion circuits 321 to operate. The two power conversion circuits 321 draw power from the energy storage device 310 and output power via the switching circuit 324 to maintain the direct-current bus 340 at the high voltage level.

Another specific embodiment of the control method for the power supply system is described below.

The direct-current converter 320 includes two power conversion circuits 321.

As shown in FIG. 2, steps 1 to 10 are included.

At step 1, it is determined whether the black-start switch 325 is turned on.

At step 2, the first auxiliary power supply 323 draws power from the energy storage device 310 to supply the auxiliary power to the internal components of the direct-current converter 320.

At step 3, after being powered on, the first controller 322 defaults to controlling the switching circuit 324 to operate in parallel output.

At step 4, the first controller 322 controls the two power conversion circuits 321 to obtain power from the energy storage device 310 and then boost the voltage of the direct-current bus 340 through the switching circuit 324.

At step 5, it is determined whether the voltage of the direct-current bus 340 is greater than or equal to the first voltage threshold.

At step 6, the second auxiliary power supply 332 obtains power from the direct-current bus 340 to supply the auxiliary power to the internal components of the grid-connected converter 330.

At step 7, after being powered on, the second controller 331 establishes communication with the first controller 322 and notifies the current voltage level of the grid-connected converter 330.

At step 8, when the voltage level is the low voltage level, the current operating state is maintained for continuous operation.

At step 9, when the voltage level is the high voltage level, the first controller 322 stops the two power conversion circuits 321 from operating.

At step 10, the output of the switching circuit 324 is switched to the series output.

At step 11, the two power conversion circuits 321 are reactivated to operate.

In some embodiments, as shown in FIG. 8, embodiments of the present disclosure also provide an electronic device 800. The electronic device 800 includes a processor 801, a memory 802, and a computer program that is stored on the memory 802 and executable on the processor 801. The program is configured to implement, when executed by the processor 801, various processes of the embodiments of the control method for the power supply system described above, and can achieve the same technical effect. Details thereof are omitted herein to avoid redundancy.

Embodiments of the present disclosure also provide a non-transitory computer-readable storage medium. The non-transitory computer-readable storage medium has a computer program stored thereon. The computer program is configured to implement, when executed by a processor, the various processes of the embodiments of the control method for the power supply system described above, and can achieve the same technical effect. Details thereof are omitted herein to avoid redundancy.

The processor is the processor in the electronic device described in the above embodiments. The readable-storage medium includes a computer-readable storage medium, such as a computer read-only memory (ROM), a random access memory (RAM), a magnetic disk, or an optical disk.

Embodiments of the present disclosure also provide a computer program product. The computer program product includes a computer program. The computer program is configured to implement, when executed by a processor, the control method for the power supply system described above.

The processor is the processor in the electronic device described in the above embodiments. The readable storage medium includes a computer-readable storage medium, such as a computer read-only memory (ROM), a random access memory (RAM), a magnetic disk, or an optical disk.

Embodiments of the present disclosure also provide a chip. The chip includes a processor and a communication interface. The communication interface is coupled to the processor. The processor is configured to execute a program or instructions to implement the various processes of the embodiments of the control method for the power supply system described above, and can achieve the same technical effect. Details thereof are omitted herein to avoid redundancy.

It should be understood that the chip mentioned in the embodiments of the present disclosure can also be referred to as a system-level chip, a system chip, a chip system, or a system-on-chip, etc.

It should be noted that, terms herein "comprise", "include" or any other variations thereof are meant to cover non-exclusive including, such that the process, method, article or device including a series of elements do not only include those elements, but also include other elements that are not explicitly listed, or also include inherent elements of the process, method, article or device. In a case that there are no more restrictions, an element qualified by the statement "comprises a ..." does not exclude the presence of additional identical elements in the process, method, article or device that includes the said element. In addition, it should be noted that the scope of the methods and devices in the implementations of the present disclosure are not limited to performing the functions in the order shown or discussed, and may also include performing the functions in a substantially simultaneous manner or in a reverse order according to the involved functions. For example, the described methods may be performed in an order different from the described order, and various steps may be added, omitted, or combined. In addition, features described with reference to some examples may be combined in other examples.

From the above description of the implementations, those skilled in the art may clearly understand that the methods of the above embodiments can be implemented by software and a necessary general hardware platform. Of course, the method can also be implemented by hardware, but the former is a preferred implementation in many cases. Based on such understanding, the technical solutions of the present disclosure essentially, or the part contributing to the related art may be embodied in a form of a software product. The computer software product is stored in a storage medium (such as ROM/RAM, a magnetic disk, and an optical disc), and includes several instructions for allowing a terminal to execute methods described in the embodiments of the present disclosure.

The embodiments of the present disclosure have been described above with reference to the accompanying drawings, but the present disclosure is not limited to the above-described specific implementations, which are merely schematic and not restrictive, and those skilled in the art can make many forms under the inspiration of the present disclosure without departing from the purpose of the present disclosure and the scope of the claims, all of which fall within the protection of the present disclosure.

In the description of this specification, descriptions with reference to the terms "an embodiment", "some embodiments", "schematic embodiments", "examples", "specific examples", or "some examples", etc., mean that specific features, structure, materials, or characteristics described in conjunction with the embodiment or example are included in at least one embodiment or example of the present disclosure. In this specification, the schematic representations of the above terms do not necessarily refer to the same embodiment or example. Moreover, the described specific features, structures, materials or characteristics may be combined in any one or more embodiments or examples in a suitable manner.

Although the embodiments of the present disclosure have been shown and described above, it can be understood by those skilled in the art that various changes, modifications, replacements, and variations can be made to these embodiments without departing from the principles and ideas of the present disclosure. The scope of the present disclosure is defined by the claims as attached and their equivalents.

## Claims

1. A control method for a power supply system, wherein:
the power supply system comprises an energy storage device, a direct-current converter, and a grid-connected converter, the direct-current converter comprising at least two power conversion circuits, the direct-current converter having an end connected to the energy storage device and another end connected to a direct-current bus, and the grid-connected converter having an end connected to the direct-current bus and another end configured to be connected to the power grid; and
the method comprises:
when the power supply system is in a black-start process and the at least two power conversion circuits are connected in a first electrical connection mode, in response to a voltage of the direct-current bus being less than a first voltage threshold, controlling the at least two power conversion circuits in the direct-current converter to output electric energy from the energy storage device to the direct-current bus;
in response to the voltage of the direct-current bus being greater than or equal to the first voltage threshold and the grid-connected converter being activated, obtaining voltage information at the end of the grid-connected converter that is connected to the direct-current bus; and
adjusting an electrical connection mode between the at least two power conversion circuits in the direct-current converter based on the voltage information, such that a direct-current output voltage of the direct-current converter matches a voltage at the end of the grid-connected converter that is connected to the direct-current bus.

2. The control method according to claim 1, wherein said adjusting the electrical connection mode between the at least two power conversion circuits in the direct-current converter based on the voltage information comprises:
determining a voltage level of the voltage at the end of the grid-connected converter that is connected to the direct-current bus based on the voltage information; and
based on the voltage level, adjusting the at least two power conversion circuits to be connected in a second electrical connection mode, or maintaining the at least two power conversion circuits to be connected in the first electrical connection mode, wherein the direct-current output voltage corresponding to the second electrical connection mode is higher than the direct-current output voltage corresponding to the first electrical connection mode.

3. The control method according to claim 2, wherein:
the voltage levels comprise a first voltage level and a second voltage level, the first voltage level being higher than the second voltage level; and
said based on the voltage level, adjusting the at least two power conversion circuits to be connected in the second electrical connection mode, or maintaining the at least two power conversion circuits to be connected in the first electrical connection mode comprises:
adjusting the at least two power conversion circuits to be connected in the second electrical connection mode in response to the voltage level being the first voltage level.

4. The control method according to claim 2, wherein:
the voltage levels comprise a first voltage level and a second voltage level, the first voltage level being higher than the second voltage level; and
said based on the voltage level, adjusting the at least two power conversion circuits to be connected in the second electrical connection mode, or maintaining the at least two power conversion circuits to be connected in the first electrical connection mode comprises:
maintaining the at least two power conversion circuits to be connected in the first electrical connection mode in response to the voltage level being the second voltage level.

5. The control method according to any one of claims 1 to 4, wherein said adjusting the electrical connection mode between the at least two power conversion circuits in the direct-current converter based on the voltage information comprises:
adjusting the at least two power conversion circuits to be connected in series and/or in parallel based on the voltage information.

6. The control method according to any one of claims 1 to 4, further comprising, subsequent to said obtaining the voltage information at the end of the grid-connected converter that is connected to the direct-current bus and prior to said adjusting the electrical connection mode between the at least two power conversion circuits in the direct-current converter: controlling the at least two power conversion circuits to stop operating.

7. A control apparatus for a power supply system, wherein:
the power supply system comprises an energy storage device, a direct-current converter, and a grid-connected converter, the direct-current converter comprising at least two power conversion circuits, the direct-current converter having an end connected to the energy storage device and another end connected to a direct-current bus, and the grid-connected converter having an end connected to the direct-current bus and another end configured to be connected to the power grid; and
the apparatus comprises:
a first processing module configured to, when the power supply system is in a black-start process and the at least two power conversion circuits are connected in a first electrical connection mode, control the at least two power conversion circuits in the direct-current converter to output electric energy from the energy storage device to the direct-current bus in response to a voltage of the direct-current bus being less than a first voltage threshold;
a second processing module configured to obtain voltage information at the end of the grid-connected converter that is connected to the direct-current bus in response to the voltage of the direct-current bus being greater than or equal to the first voltage threshold and the grid-connected converter being activated; and
a third processing module configured to adjust an electrical connection mode between the at least two power conversion circuits in the direct-current converter based on the voltage information, such that a direct-current output voltage of the direct-current converter matches a voltage at the end of the grid-connected converter that is connected to the direct-current bus.

8. A power supply system, comprising:
an energy storage device;
a direct-current converter comprising at least two power conversion circuits, an end of the direct-current converter being connected to the energy storage device, and another end of the direct-current converter being connected to a direct-current bus; and
a grid-connected converter, an end of the grid-connected converter being connected to the direct-current bus, and another end of the grid-connected converter being configured to be connected to the power grid,
wherein the direct-current converter further comprises a first controller configured to execute the control method for the power supply system according to any one of claims 1 to 6.

9. The power supply system according to claim 8, wherein the direct-current converter further comprises:
a switching circuit connected to output ends of the at least two power conversion circuits, the switching circuit comprising a plurality of switching devices, wherein the first controller is configured to control a switching state of each of the plurality of switching devices to adjust an electrical connection mode between the at least two power conversion circuits.

10. The power supply system according to claim 8 or 9, wherein the grid-connected converter comprises:
a second controller communicatively connected to the first controller, the second controller being configured to transmit the voltage information at the end of the grid-connected converter that is connected to the direct-current bus to the first controller in response to the voltage of the direct-current bus being greater than or equal to the first voltage threshold and the grid-connected converter being activated.
